(19) Europäisches Patentamt
European Patent Office
Office européen des brevets

(11) Publication number: **0 619 519 A1**

# (12) EUROPEAN PATENT APPLICATION

(21) Application number: **94200771.7**

(51) Int. Cl.[5]: **G03F 7/021**, C08G 61/12

(22) Date of filing: **24.03.94**

(30) Priority: **06.04.93 IT MI930679**

(43) Date of publication of application: **12.10.94 Bulletin 94/41**

(84) Designated Contracting States: **AT BE CH DE DK ES FR GB IE LI NL SE**

(71) Applicant: **LASTRA S.P.A.**
**Via Brescia, 36**
**I-25025 Manerbio (IT)**

(72) Inventor: **Canestri, Giuseppe**
**Via Parisano, 84**
**I-47037 Rimini, (Forli) (IT)**
Inventor: **De Candido, Stefano**
**Via Baldasseria Bassa, 61/5**
**I-33100 Udine (IT)**

(74) Representative: **Marchi, Massimo et al**
**c/o Marchi & Mittler s.r.l.**
**Viale Lombardia 20**
**I-20131 Milano (IT)**

## (54) Photosensitive polycondensation compound for negative lithographic plates.

(57) Process for preparing a photosensitive polycondensation compound in the presence of condensing medium which is a mixture containing from 30 to 5 parts by weight of 98% aqueous methanesulfonic acid and from 70 to 95 parts by weight of 85% aqueous phosphoric acid, respectively.

Thus obtained polycondensation compound and printing plates containing it.

EP 0 619 519 A1

It is known that aromatic diazonium salts are the most widely used photosensitive compounds for the production of lithographic plates.

To improve their properties, many condensation products of photosensitive aromatic diazonium compounds have been prepared from various compounds with the intent of obtaining high molecular weight compounds containing aromatic diazonium groups.

All these condensation reactions have been carried out in the presence of a mineral acid or strong organic acid such as sulphuric acid, phosphoric acid, hydrofluoric acid, hydrochloric acid, hydrobromic acid, benzenesulfonic acid, toluenesulfonic acid, methanesulfonic acid and ethanesulfonic acid.

Generally, these studies had the aim of identifying the starting compounds which yield the best condensation products. However, as far as it is known, the importance of the role played by the nature of the condensation acid medium on the nature of the condensation products has never been understood.

US-A-3,849,392 (Kalle A.G.) discloses a process for preparing photosensitive compounds which comprises polycondensing, in a strongly acidic medium, 1 unit of an aromatic diazonium compound with from 0.1 to 50 units of an aromatic compound having from 1 to 10 aliphatic alkoxy or acyloxy groups. Typical examples of strong acids are sulphuric acid, phosphoric acid and methanesulfonic acid (column 9, line 20).

In this patent it is also stated that in order to yield good, results the polycondensation compounds must have a weight of from 500 to 10,000 (see col. 11, lines 29-32).

This range is very wide and the inventor does not specify whether he refers to the average weight or, especially as far as the upper limit of the range is concerned, to the weight of a minimum fraction.

Similarly, the inventor does not teach how it is possible to prepare polycondensation compounds having an average molecular weight greater than 3,000.

In fact, the only example wherein the mean molecular weight of the polycondensation products has been mentioned is Example 42. Specifically, this example relates to the preparation of two polycondensation products which yield, with 1-phenyl-3-methyl-5-pyrazolone, a dyestuff having an mean molecular weight of 3,180 and, respectively, 2,390, which corresponds to an mean weight of the polycondensation product of about 2,900 and 2150, respectively.

US-A-3,867,147 (Am. Hoechst Corp.) relates to polycondensation products prepared according to the method described in the previous patent US-A-3,849,392 as well as photosensitive materials containing them.

However, Examples 3, 13 and 14 of US-A-4,533,620 (Am. Hoechst Corp.) show that the plates prepared with the polycondensation compounds of US-A-3,849,392 and US-A-3,867,147 yield easily degradable images when the photosensitive plate has been prepared using the electrocathodic deposition technique, or are poorly photosensitive and have a unsatisfactory mean life when the plate has been prepared using the immersion technique.

To overcome these problems the aforesaid patent, US-A-4,533,620 proposes a wide range of condensation products where one or more aromatic diazonium compounds are reacted with formaldehyde, or suitable monomers or oligomers which are able to react or to become a part of the aromatic structure of the aromatic diazonium compounds. Typical examples of the abovementioned monomers and oligomers are the homocondensates of 4,4'-Bis-methoxymethyldiphenylether.

Also, the condensation reactions of the patent US-A-4,533,620 are carried out in the presence of an acid medium such as sulphuric acid or phosphoric acid (see col. 4, lines 26-30).

Now, it has been surprisingly found that the condensation medium can play a fundamental and unexpected role with respect to the structure of the polycondensation compound.

The present invention lies on the unexpected finding that, starting from the very same materials, novel final condensation products are yielded when the condensation reaction is carried out in the presence of an acid medium consisting of a mixture containing from 30-5% by weight of 98% methanesulfonic acid and, respectively, from 70-95% of 85% phosphoric acid.

Aboveall, the novelty of the compounds of this invention is evidenced by a higher mean molecular weight (Tables 1-12), a higher number of printed copies (Tables 13-14), an improved mechanical resistance (Tables 15-18), an improved solvent resistance (Tables 19-20), and an improved photosensitivity (Tables 20-21).

The best results have been obtained using, as the starting materials, aromatic diazonium compounds of the formula:

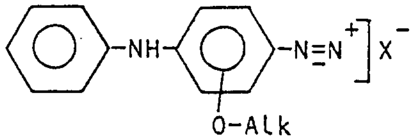

(A)

and alkoxymethyl compounds having the formula:

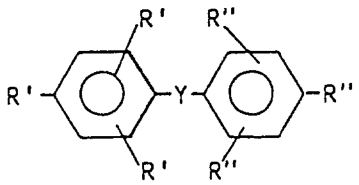

(B)

where $X^-$ is $HSO_4{}^-$, $Cl^-$, $H_2PO_4{}^-$;

Y is O, NH, S, $CH_2$, $C(CH_3)_2$, CH(OH)CO , CO, CONH, SO, or CH = CH;

one or two R' substituents are Alk-O-$CH_2$ and the remaining substituents R' are hydrogen;

from zero to two R'' substituents are Alk-O-$CH_2$ and the remaining R'' substituents are hydrogen;

Alk is an alkyl having from one to four carbon atoms.

Therefore a first object of this invention is to provide a process for condensing in an acid medium, an aromatic diazonium compound of the formula:

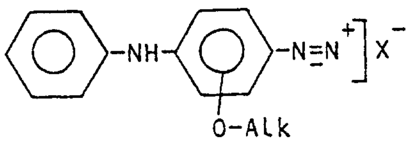

(A)

with an alkoxymethyl compound of the formula:

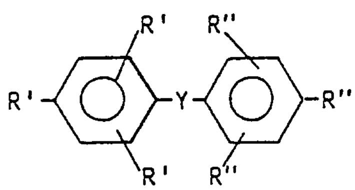

(B)

where $X^-$ is $HSO_4{}^-$, $Cl^-$, $H_2PO_4{}^-$;

Y is O, NH, S, $CH_2$, $C(CH_3)_2$ , CH(OH)CO , CO, CONH, SO, or CH = CH;

one or two R' substituents are Alk-O-$CH_2$ and the remaining R' substituents are hydrogen;

from zero to two R'' substituents are Alk-O-$CH_2$ and the remaining R'' substituents are hydrogen;

Alk is an alkyl having from one to four carbon atoms. characterized in that the condensation medium is a mixture containing from 30 to 5 parts by weight of 98% aqueous methanesulfonic acid and from 70 to 95 parts by weight of 85% aqueous phosphoric acid, respectively.

Preferably, the condensation medium is made of from 20 to 5 parts by weight of 98-99% aqueous methanesulfonic acid and from 80 to 95 parts by weight of 85% aqueous phosphoric acid, respectively.

The process of this invention is preferably carried out by reacting from 50 to 60 parts by weight of A with from 40 to 50 parts by weight of B. Thus, the photosensitive polycondensation compound according to this invention contains from 50 to about 60% by weight of compound A.

In general, the polycondensation reaction is carried out by dissolving compound A in the acid medium and by adding then compound B, at a temperature lower than 70 °C. Preferably, the temperature is of from 24 to 32 °C.

The reaction time is preferably less than 36 hours. At 40 °C the reaction time is preferably of about 18 hours.

It has also been found that the photosensitive polycondensation compounds prepared according to this invention have excellent properties when they have just been made. However, their properties deteriorate with aging. This is particularly evident for the photosensitive polycondensation compounds prepared from mixtures of compound (B) which are variously substituted such as, for example, the mixtures comprising 4,4'-Bis-alkoxymethyldiphenylether, monoalkoxydiphenylether, 2,4'-Bis-alkoxymethyldiphenylether, tri- and tetra-alkoxymethyldiphenylether.

However, this drawback can be overcame by freeze drying the photosensitive polycondensation compound as soon as it is prepared. This is another characteristic of the process of this invention.

Compound B can be prepared according to many known methods such as those described in the French patent 1,321,757, in the US patents 3,316,186, 4,413,149 and 4,457,810, and according to the documents referred to therein.

A further object of this invention is to provide a photosensitive polycondensation compound containing from 50 to about 60% by weight of A and from 40 to about 50% by weight of compound B units characterized in that

- it has been prepared by condensation, in an acid medium, of from 50 to 60 parts by weight of an aromatic diazonium compound of the formula:

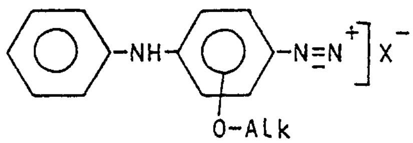

(A)

with from 40 to 50 parts by weight of an alkoxymethyl compound of the formula:

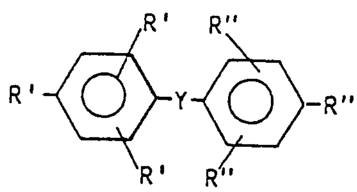

(B)

where $X^-$ is $HSO_4^-$, $Cl^-$, $H_2PO_4^-$;

Y is O, NH, S, $CH_2$, $C(CH_3)_2$, CH(OH)CO , CO, CONH, SO, or CH = CH;

one or two R' substituents are Alk-O-$CH_2$ and the remaining substituents R' are hydrogen;

from zero to two R'' substituents are Alk-O-$CH_2$ and the remaining R'' substituents are hydrogen;

Alk is an alkyl having from one to four carbon atoms, said acid medium being a mixture of from 30 to 5 parts by weight of 98% aqueous methanesulfonic acid and of from 70 to 95 parts by weight of 85% aqueous phosphoric acid, respectively,

- it has a mean molecular weight higher than 3.000.

Still another object of this invention is to provide printing plates wherein the photosensitive ingredient is at least one polycondensation compound containing from 50 to about 60% by weight of A and from 40 to about 50% by weight of compound B units, characterized in that

- it has been prepared by condensation, in an acid medium, of from 50 to 60 parts by weight of an aromatic diazonium compound of the formula:

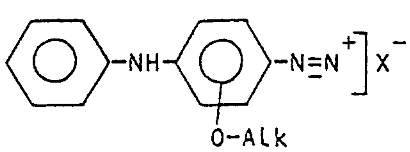

(A)

with from 40 to 50 parts by weight of an alkoxymethyl compound of the formula:

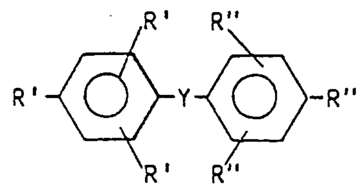

(B)

where $X^-$ is $HSO_4^-$, $Cl^-$, $H_2PO_4^-$;

Y is O, NH, S, $CH_2$, $C(CH_3)_2$, CH(OH)CO , CO, CONH, SO, or CH = CH;

one or two R' substituents are Alk-O-$CH_2$ and the remaining substituents R' are hydrogen;

from zero to two R'' substituents are Alk-O-$CH_2$ and the remaining R'' substituents are hydrogen;

Alk is an alkyl having from one to four carbon atoms, said acid medium being a mixture of from 30 to 5 parts by weight of 98% aqueous methanesulfonic acid and of from 70 to 95 parts by weight of 85% aqueous phosphoric acid, respectively,

- it has a mean molecular weight higher than 3.000.

The following experimental section is intended to further illustrate this invention without, however, limiting it in any way.

In the following experimental section the term "parts" refers to parts by weight when not otherwise stated.

GENERAL METHODS FOR THE PREPARATION OF THE COMPOUNDS OF THE PRESENT INVENTION

**METHOD 1**

Step A: Polycondensation

48-50 parts of a compound A in sulfate form ($X^-$ = $HSO_4^-$) are added in 30 minutes to a mixture of 150-210 (preferably 178-185) parts of 85% aqueous phosphoric acid and 22-29 (preferably 25-29) parts of 99% methanesulfonic acid, in a glass vessel, at a temperature of 20-25 °C.

The temperature is raised to 28-32 °C and the reaction mixture is maintained at this temperature for 0.5 h. Then 35 parts of a mixture of a compound B are added under vigorous stirring in 1.75 h.

The temperature is raised to 40 °C and the mixture is maintained under stirring for 18 h.

Step B: Substitution of the sulfate anion with the chloride anion

The reaction mixture is poured into 3,000 parts of water, maintained at 30-34 °C, under stirring. The reaction vessel is washed with 500 parts of water and the washing water is added to the reaction mixture under stirring.

The reaction mixture is maintained under stirring for 30 minutes and then it is added, under stirring, to a solution of 1,230 parts of sodium chloride in 2,800 parts of water at 30-34 °C.

The mixture is maintained under stirring for a further 1.5 h. The water is then removed from the solid product formed by quick filtration under vacuum.

Step C: Substitution of the chloride anion with an organic anion

The filtered solid is suspended in 2,500 parts of water at 30-34 °C under stirring. For every part by weight of the diazonium group of the polycondensation compound, an aqueous solution containing about 1.2 parts of a compound selected from sodium hydroxybenzophenonesulfonate, naphthalenesulfonate, toluenesulfonate, benzenesulfonate, mesitylenesulfonate, xylenesulfonate and similar aromatic sulfonates, is quickly added to the reaction mixture.

The reaction mixture is maintained under stirring at 30-34 °C for approximately 2 h. The solid formed is separated from the water by filtration under vacuum and is then washed with 5,000 parts of water at 26 °C under stirring for 1 h.

The solid is again separated by filtration under vacuum and the still humid product is placed in glass containers which are then sealed and frozen for 16 h at about -15 °C. The product is then freeze dried.

The final yields, with respect to the starting compounds A and B, are about 75-78% by weight of the theoretical yield.

**METHOD 2**

This method differs from Method 1 because it involves the direct substitution of the sulphate anion with an organic anion.

The reaction mixture obtained according to Step A of Method 1 is treated directly as described in Step C of Method 1.

The thus obtained products are endowed with substantially the same characteristics and properties as those prepared with Method 1 from the same amounts of the starting Compounds A and B. The final yields, with respect to the starting Compounds A and B, are about 85-88% by weight of the theoretical yield.

SPECIFIC EXAMPLES OF THE PREPARATION OF THE COMPOUNDS ACCORDING TO THE PRESENT INVENTION

**EXAMPLE 1**

A first polycondensation compound (COMPOUND 1) of this invention has been prepared with the following procedure:

| | |
|---|---|
| procedure | Method 2 |
| compound A | 3-methoxydiphenylamine-4-diazosulphate, 97 parts; |
| compound B | 70 parts of a mixture consisting of: 68.8% of 4,4'-Bis-methoxymethyldiphenylether, 20.2% of trimethoxymethyldiphenylether, 9.4% of 2,4'-Bis-methoxymethyldiphenylether, 1.6% of tetramethoxymethyldiphenylether; |
| acid medium | 366 parts of 85% aqueous phosphoric acid, and 55 parts of 98% methanesulfonic acid; |
| condensation time | 18 h; |
| final separated form | mesitylenesulfonic acid salt (light yellow powder). |
| yield | 208 parts. |

An aliquot (10 g) of COMPOUND 1 was converted into a dyestuff with 1-phenyl-3-methyl-5-pyrazolone; the mean molecular weight of the thus prepared dyestuff has been determined according to the method described in the American patent US-A-3,849,392 (see col. 43, lines 35-38 and 57-63).

The application to the support of the chloroformic solution of the dyestuff was performed by coating.

The results are shown in the following table:

Table 1

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150 | 2.0 | 0.15 | 680 | 12.1 |
| 2 | 60.0 | 90.0 | 13.8 | 1.05 | 950 | 11.9 |
| 3 | 67.5 | 82.5 | 64.8 | 4.95 | 1,180 | 9.98 |
| 4 | 75.0 | 75.0 | 73.2 | 5.60 | 1,450 | 9.75 |
| 5 | 82.5 | 67.5 | 85.4 | 6.53 | 1,890 | 9.68 |
| 6 | 90.0 | 60.0 | 103.6 | 7.92 | 2,385 | 9.01 |
| 7 | 97.5 | 52.5 | 224.1 | 17.12 | 5,100 | 8.75 |
| 8 | 105.0 | 45.0 | 380.4 | 29.07 | 7,950 | 8.61 |
| 9 | 112.5 | 37.5 | 361.4 | 27.61 | 8,650 | 8.20 |
| | | | 1308.7 | 100.00 | | |

**EXAMPLE 2**

A second polycondensation compound (COMPOUND 2) of this invention has been prepared with the following procedure:

| | |
|---|---|
| procedure | Method 2 |
| compound A | 3-methoxydiphenylamine-4-diazosulphate, 97 parts; |
| compound B | 4,4'-Bis-methoxymethyldiphenylether (98-99%), 70 parts; |
| acid medium | 366 parts of 85% aqueous phosphoric acid, and 55 parts of 98% methanesulfonic acid; |
| condensation time | 18 h; |
| final separated form | mesitylenesulfonic acid salt. |
| yield | 218 parts (93% of the theoretical). |

An aliquot (10 g) of COMPOUND 2 was converted into a dyestuff with 1-phenyl-3-methyl-5-pyrazolone; the mean molecular weight of the thus prepared dyestuff has been determined according to the method described by US-A-3,849,392 (see col. 43, lines 35-38 and 57-63).

The application to the support of the chloroformic solution of the dyestuff was performed by coating.

The results are shown in the following table:

Table 2

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150.00 | 3.5 | 0.25 | 620 | 12.30 |
| 2 | 60.0 | 90.00 | 14.2 | 1.00 | 850 | 12.00 |
| 3 | 67.5 | 82.50 | 62.7 | 4.43 | 1,680 | 9.60 |
| 4 | 75.0 | 75.00 | 78.9 | 5.57 | 2,150 | 9.20 |
| 5 | 82.5 | 67.50 | 92.5 | 6.53 | 3,350 | 9.00 |
| 6 | 90.0 | 60.00 | 115.0 | 8.12 | 4,230 | 8.90 |
| 7 | 97.5 | 52.50 | 232.4 | 16.42 | 5,860 | 8.31 |
| 8 | 105.0 | 45.00 | 485.6 | 34.30 | 8,350 | 7.95 |
| 9 | 112.5 | 37.50 | 330.8 | 23.38 | 8,980 | 7.61 |
| | | | 1415.6 | 100.00 | | |

COMPARISON EXAMPLES

**COMPARISON EXAMPLE 1**

A comparison polycondensation compound (COMPARISON COMPOUND 1) has been prepared exactly as described in the Example 1 above except that the acid medium was consisting of 415 parts of 85% aqueous phosphoric acid without any methanesulfonic acid and that the compound was not freeze dried. Yield, 180 parts (77% of the theoretical).

An aliquot (10 g) of the COMPARISON COMPOUND 1 was converted into a dyestuffstuff with 1-phenyl-3-methyl-5-pyrazolone; the mean molecular weight of the thus prepared dyestuff has been determined according to the method described by US-A-3,849,392 (see col. 43, lines 35-38 and 57-63).

The application to the support of the chloroformic solution of the dyestuff was performed by coating.

The results are shown in the following table:

Table 3

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150.00 | 2.2 | 0.17 | 630 | 12.28 |
| 2 | 60.0 | 90.00 | 8.6 | 0.69 | 780 | 12.15 |
| 3 | 67.5 | 82.50 | 58.8 | 4.73 | 1,320 | 12.00 |
| 4 | 75.0 | 75.00 | 73.4 | 5.89 | 1,585 | 11.98 |
| 5 | 82.5 | 67.50 | 90.8 | 7.29 | 2,110 | 11.85 |
| 6 | 90.0 | 60.00 | 106.9 | 8.58 | 2,650 | 11.70 |
| 7 | 97.5 | 52.50 | 200.8 | 16.12 | 2,980 | 11.60 |
| 8 | 105.0 | 45.00 | 495.5 | 39.78 | 3,230 | 11.45 |
| 9 | 112.5 | 37.50 | 208.6 | 16.75 | 3,640 | 11.30 |
| | | | 1245.6 | 100.00 | | |

**COMPARISON EXAMPLE 2**

A second comparison polycondensation compound (COMPARISON COMPOUND 2) has been prepared exactly as described in the Example 2 above except that the acid medium was consisting of 415 parts of 98% methanesulfonic acid without any phosphoric acid and that the compound was not freeze dried. Yield, 60 parts (25% of the theoretical).

An aliquot (10 g) of COMPARISON COMPOUND 2 was converted into a dyestuff with 1-phenyl-3-methyl-5-pyrazolone; the mean molecular weight of the dyestuff thus prepared has been determined according to the method described by US-A-3,849,392 (see col. 43, lines 35-38 and 57-63).

The application to the support of the chloroformic solution of the dyestuff was performed by coating.

The results are shown in the following table:

Table 4

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150.0 | 3.8 | 0.30 | 580 | 12.44 |
| 2 | 60.0 | 90.0 | 9.4 | 0.72 | 660 | 12.42 |
| 3 | 67.5 | 82.5 | 62.3 | 4.80 | 1,110 | 12.35 |
| 4 | 75.0 | 75.0 | 70.1 | 5.40 | 1,420 | 12.15 |
| 5 | 82.5 | 67.5 | 89.8 | 6.90 | 1,890 | 12.00 |
| 6 | 90.0 | 60.0 | 108.9 | 8.37 | 2,340 | 11.95 |
| 7 | 97.5 | 52.5 | 230.6 | 17.73 | 2,650 | 11.82 |
| 8 | 105.0 | 45.0 | 524.5 | 40.34 | 3,000 | 11.52 |
| 9 | 112.5 | 37.5 | 200.8 | 15.44 | 3,340 | 11.42 |
| | | | 1.300.20 | 100.00 | | |

**COMPARISON EXAMPLE 3**

With the same ratios by weight of the starting compounds as in Example 42 of US-A-3,849,392 the following procedure was carried out:

96.9 parts of 3-methoxydiphenylamine-4-diazosulphate were dissolved under stirring in

521 parts of 86% aqueous phosphoric acid and the solution was then added dropwise at room temperature to

77.4 parts of a mixture consisting of:

77% of 4,4'-Bis-methoxymethyldiphenylether

8% of monomethoxymethyldiphenylether

6% of 2,4'-Bis-methoxymethyldiphenylether

4% of trimethoxymethyldiphenylether

5% of tetramethoxymethyldiphenylether

The mixture was then divided into three batches each of 228.1 g.

The first batch (3A) was left to rest for 17 h at room temperature. This batch was then treated as described in the Method 2 above except that it was not freeze dried but dried in an air-circulation oven at 45°C for 64 h. The COMPARISON COMPOUND 3A was thus obtained. Yield, 59% (theoretical).

The thus obtained compound is dark brown and glass-like.

The second batch (3B) was maintained under stirring for 4.5 h at 40°C, according to the Example 42 of US-A-3,849,392. The COMPARISON COMPOUND 3B was thus obtained. Yield, 64% (theoretical).

The thus obtained compound is dark brown and glass-like.

25 parts of methanesulfonic acid were added under stirring to the third batch (3C) in 5 minutes according to the present invention. The temperature was raised to 40°C and this temperature was maintained for 18 h. The reaction mixture was then treated as described in Method 2, frozen and freeze dried at 45°C for 64 h. The COMPOUND 3C of the present invention was thus obtained. Yield, 79% (theoretical).

COMPOUND 3D of the present invention was prepared in a manner similar as for COMPOUND 3C except that there was used 98.2% 4,4'-Bis-methoxymethyldiphenylether comprising:

98.2% of 4,4'-Bis-methoxymethyldiphenylether

0.8% of 2,4'-Bis-methoxymethyldiphenylether

0.8% of trimethoxymethyldiphenylether

0.2% of trimethoxymethyldibenzopyrane

The yield was 77% (theoretical).

The COMPARISON COMPOUNDS 3A and 3B and COMPOUNDS 3C and 3D of the present invention were converted into salts of the mesitylenesulfonic acid according to the method described in the Example 42 of US-A-3,849,392, col. 43, lines 25-27.

An aliqout (10 g) of each mesitylenesulfonate of the COMPARISON COMPOUNDS 3A and 3B and COMPOUNDS 3C and 3D of the present invention was converted into a dyestuff, in ammoniacal medium, with 1-phenyl-3-methyl-5-pyrazolone, and the mean molecular weight of each dyestuff thus prepared was determined according to the method described by US-A-3,849,392 (col. 43, lines 34-38 and 57-63).

The application to the support of the chloroformic solutions of the abovementioned dyestuffs was performed by coating.

The results are shown in the following Tables from 5 to 8.

COMPARISON COMPOUND 3A

Table 5

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150.0 | 3.3 | 0.26 | 620 | 12.30 |
| 2 | 60.0 | 90.0 | 14.5 | 1.15 | 750 | 12.25 |
| 3 | 67.5 | 82.5 | 67.9 | 5.40 | 1,005 | 11.92 |
| 4 | 75.0 | 75.0 | 80.8 | 6.41 | 1,200 | 11.88 |
| 5 | 82.5 | 67.5 | 98.9 | 7.85 | 1,430 | 11.84 |
| 6 | 90.0 | 60.0 | 159.7 | 12.69 | 1,780 | 11.75 |
| 7 | 97.5 | 52.5 | 278.5 | 22.11 | 3,650 | 11.25 |
| 8 | 105.0 | 45.0 | 395.8 | 31.43 | 4,235 | 10.88 |
| 9 | 112.5 | 37.5 | 159.9 | 12.70 | 4,790 | 10.75 |
| | | | 1259.3 | 100.00 | | |

COMPARISON COMPOUND 3B

Table 6

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150.0 | 3.6 | 0.26 | 680 | 12.23 |
| 2 | 60.0 | 90.0 | 15.2 | 1.11 | 790 | 12.21 |
| 3 | 67.5 | 82.5 | 65.4 | 4.79 | 1,028 | 11.90 |
| 4 | 75.0 | 75.0 | 75.9 | 5.55 | 1,180 | 11.89 |
| 5 | 82.5 | 67.5 | 85.8 | 6.27 | 1,450 | 11.83 |
| 6 | 90.0 | 60.0 | 163.8 | 11.98 | 1,950 | 11.60 |
| 7 | 97.5 | 52.5 | 254.2 | 18.59 | 3,820 | 11.02 |
| 8 | 105.0 | 45.0 | 475.2 | 34.75 | 4,830 | 10.65 |
| 9 | 112.5 | 37.5 | 228.3 | 16.70 | 5,385 | 10.42 |
| | | | 1367.4 | 100.00 | | |

COMPOUND 3C

Table 7

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150.0 | 3.8 | 0.29 | 740 | 12.20 |
| 2 | 60.0 | 90.0 | 13.9 | 1.06 | 860 | 12.00 |
| 3 | 67.5 | 82.5 | 68.2 | 5.21 | 1,186 | 9.96 |
| 4 | 75.0 | 75.0 | 76.3 | 5.83 | 1,519 | 9.68 |
| 5 | 82.5 | 67.5 | 85.2 | 6.54 | 1,982 | 9.60 |
| 6 | 90.0 | 60.0 | 106.0 | 8.10 | 2,260 | 9.20 |
| 7 | 97.5 | 52.5 | 225.6 | 17.25 | 4,962 | 8.88 |
| 8 | 105.0 | 45.0 | 440.2 | 33.66 | 7,935 | 8.61 |
| 9 | 112.5 | 37.5 | 288.6 | 22.06 | 8,296 | 8.40 |
| | | | 1307.8 | 100.00 | | |

COMPOUND 3D

Table 8

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150.0 | 4.2 | 0.30 | 600 | 12.40 |
| 2 | 60.0 | 90.0 | 14.6 | 1.03 | 790 | 12.10 |
| 3 | 67.5 | 82.5 | 66.4 | 4.69 | 1,580 | 9.65 |
| 4 | 75.0 | 75.0 | 74.5 | 5.25 | 2,090 | 9.35 |
| 5 | 82.5 | 67.5 | 91.2 | 6.42 | 3,530 | 9.25 |
| 6 | 90.0 | 60.0 | 115.3 | 8.12 | 4,410 | 9.00 |
| 7 | 97.5 | 52.5 | 230.0 | 16.20 | 5,805 | 8.20 |
| 8 | 105.0 | 45.0 | 472.9 | 33.29 | 8,310 | 7.98 |
| 9 | 112.5 | 37.5 | 350.6 | 24.70 | 8,960 | 7.65 |
| | | | 1419.2 | 100.00 | | |

**COMPARISON EXAMPLE 4**

With the same ratios by weight of the starting compounds as indicated in Example 3 US-A-4.533.620 the following procedure was carried out:

97 parts of 3-methoxydiphenylamine-4-diazosulphate were dissolved under stirring in

436.5 parts of 86% aqueous phosphoric acid which were then added dropwise in 2.5 h at 40 °C to

71.3 parts of a mixture consisting of:

58.1% of 2,4,4'-trimethoxymethyldiphenylether

29.5% of 4,4'-Bis-methoxymethyldiphenylether

5.0% of trimethoxymethyldibenzopyrane

2.7% of 2,4'-dimethoxymethyldiphenylether

1.9% of dimethoxymethyldibenzopyrane

1.1% of dimethoxymethylhydroxymethyldiphenylether

1.0% of 4-hydroxymethyl-4'-methoxymethyldiphenylether

0.3% of xylene

0.2% of 2,4-dimethoxymethyldiphenylether

0.1% of methoxymethyldibenzopyrane

0.1% of 4-methoxymethyldiphenylether

The mixture was then divided into three batches each of 201.59 g.

The first batch (4A) was left to rest for 17 h at room temperature as described in Example 3 of US-A-4,533,620. This batch was then treated as described in US-A-3,849,392 (col. 43, lines 25-28). The COMPARISON COMPOUND 4A was thus obtained and was converted into the phosphate salt according to conventional techniques, then the salt was filtered and dried in an air-circulation oven at 45 °C for 64 h. Yield, 52% (theoretical).

The compound is dark brown and glass-like.

The second batch (4B) was maintained under stirring for 17 h at 40 °C. This batch was then treated as described for batch 4A. The COMPARISON COMPOUND 4B was thus obtained and converted into the sulphate salt according to conventional techniques, then the salt was filtered and dried in an air-circulation oven at 45 °C for 64 h. Yield, 64% (theoretical).

3 parts of 86% aqueous phosphoric acid and 15.5 parts of methanesulfonic acid were added, according to the present invention, to the third batch (4C) and maintained under constant stirring. The temperature was raised to 40 °C and this temperature was maintained for 17 h. The reaction mixture was then treated as described in US-A-3,849,392 (col. 43, lines 25-28). The thus obtained COMPOUND 4C of the present invention was converted into a mixed salt of p-toluenesulfonic and mesitylenesulfonic acid (1:1) according to conventional techniques and then filtered, frozen and freeze dried at 45 °C for 64 h. Yield, 78% (theoretical).

In analogous manner the COMPOUND 4D of the present invention was prepared as described for COMPOUND 4C except that

- it was used 98% 4,4'-Bis-methoxymethyldiphenylether comprising:
  98.0% of 4,4'-Bis-methoxymethyldiphenylether
  1.0% of 2,4'-Bis-methoxymethyldiphenylether
  0.7% of trimethoxymethyldiphenylether
  0.3% of trimethoxymethyldibenzopyrane
- the amount of the 98% 4,4'-Bis-methoxymethyldiphenylether was the same as to the weight as in the Example 3 of US-A-4,533,620.

The reaction mixture was then treated as described in US-A-3,849,392 (col. 43, lines 25-28). The thus obtained COMPOUND 4D of the present invention was converted into a mixed salt (1:1) of both p-toluenesulfonic and mesitylenesulfonic acid according to conventional techniques and then filtered, frozen and freeze dried at 45 °C for 64 h. Yield, 81% (theoretical).

An aliqout (10 g) of each of the abovementioned salts of the COMPARISON COMPOUNDS 4A and 4B and COMPOUNDS 4C and 4D of the present invention was converted into a dyestuff, in an ammoniacal medium, with 1-phenyl-3-methyl-5-pyrazolone, and the mean molecular weight of each dyestuff thus prepared was determined according to the method described in US-A-3,849,392 (col. 43, lines 34-38 and 57-63).

The application to the aluminium support of the chloroform solutions of the abovementioned diazonium compound dyestuffs was performed by coating.

The results are shown in the following Tables from 9 to 12.

COMPARISON COMPOUND 4A

Table 9

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150.0 | 3.5 | 0.27 | 630 | 12.30 |
| 2 | 60.0 | 90.0 | 14.2 | 1.12 | 710 | 12.10 |
| 3 | 67.5 | 82.5 | 68.5 | 5.42 | 1,060 | 11.92 |
| 4 | 75.0 | 75.0 | 92.2 | 7.30 | 1,110 | 11.90 |
| 5 | 82.5 | 67.5 | 96.8 | 7.65 | 1,350 | 11.80 |
| 6 | 90.0 | 60.0 | 160.6 | 12.70 | 2,050 | 11.52 |
| 7 | 97.5 | 52.5 | 282.0 | 22.31 | 3,910 | 11.00 |
| 8 | 105.0 | 45.0 | 350.6 | 27.73 | 4,650 | 10.58 |
| 9 | 112.5 | 37.5 | 195.8 | 15.50 | 5,260 | 10.35 |
| | | | 1.264.2 | 100.00 | | |

COMPARISON COMPOUND 4B

Table 10

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150.0 | 2.9 | 0.22 | 580 | 12.50 |
| 2 | 60.0 | 90.0 | 12.8 | 0.96 | 650 | 2.21 |
| 3 | 67.5 | 82.5 | 66.4 | 5.00 | 1,030 | 11.91 |
| 4 | 75.0 | 75.0 | 81.2 | 6.13 | 1,185 | 11.88 |
| 5 | 82.5 | 67.5 | 88.6 | 6.68 | 1,520 | 11.85 |
| 6 | 90.0 | 60.0 | 158.4 | 11.92 | 2,280 | 11.49 |
| 7 | 97.5 | 52.5 | 284.5 | 21.47 | 4,110 | 11.06 |
| 8 | 105.0 | 45.0 | 465.8 | 35.15 | 5,850 | 10.40 |
| 9 | 112.5 | 37.5 | 165.3 | 12.47 | 6,280 | 10.30 |
| | | | 1325.9 | 100.00 | | |

COMPOUND 4C

Table 11

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150.0 | 2.1 | 0.15 | 630 | 12.20 |
| 2 | 60.0 | 90.0 | 14.5 | 1.03 | 720 | 12.10 |
| 3 | 67.5 | 82.5 | 67.2 | 4.77 | 1,201 | 10.00 |
| 4 | 75.0 | 75.0 | 74.5 | 5.30 | 1,480 | 9.81 |
| 5 | 82.5 | 67.5 | 83.5 | 5.93 | 1,950 | 9.60 |
| 6 | 90.0 | 60.0 | 103.2 | 7.33 | 2,480 | 9.30 |
| 7 | 97.5 | 52.5 | 223.0 | 15.86 | 5,050 | 8.78 |
| 8 | 105.0 | 45.0 | 482.5 | 34.30 | 7,850 | 8.69 |
| 9 | 112.5 | 37.5 | 356.5 | 25.33 | 8,990 | 7.88 |
| | | | 1407.0 | 100.00 | | |

COMPOUND 4D

Table 12

| fraction No. | $CHCl_3$ (ml) | $CH_3OH$ (ml) | fraction amount (mg) | fraction amount (%) | mean molecular weight | mean N (%) |
|---|---|---|---|---|---|---|
| 1 | - | 150.0 | 3.8 | 0.27 | 590 | 12.55 |
| 2 | 60.0 | 90.0 | 13.8 | 0.98 | 785 | 12.30 |
| 3 | 67.5 | 82.5 | 64.7 | 4.62 | 1,610 | 9.55 |
| 4 | 75.0 | 75.0 | 73.8 | 5.27 | 2,020 | 9.40 |
| 5 | 82.5 | 67.5 | 90.8 | 6.48 | 3,450 | 8.88 |
| 6 | 90.0 | 60.0 | 112.0 | 8.00 | 4,350 | 8.60 |
| 7 | 97.5 | 52.5 | 240.0 | 17.14 | 5,910 | 8.20 |
| 8 | 105.0 | 45.0 | 460.6 | 32.92 | 8,380 | 7.90 |
| 9 | 112.5 | 37.5 | 340.5 | 24.32 | 8,990 | 7.60 |
| | | | 1400.0 | 100.00 | | |

TESTS

**TEST 1. PREPARATION OF PHOTOSENSITIVE PLATES BY CONTACT**

Into a flat-plate centrifuge there was placed an aluminium plate (alloy No. 1,050) of 250 $cm^2$ which had previously been anodized and grained with conventional techniques and further treated with an aqueous solution of polyvinylphosphonic acid (10 g/l).

Onto this plate there are spread, by means of the centrifuge, 0.25 g of a photosensitive emulsion consisting of:

10 parts of photosensitive a polycondensation compound;

89 parts of etylene glycol mono methylether;

0.3 parts of a conventional leveler (FLUORAD FC-430™ , 3M), and;

0.1 parts of a conventional soluble dyestuff (HEKTOVIOLET-612™ , BASF).

The centrifuge is run for 5 minutes at 300 rpm; the plate is then dried in an air-circulation oven for 3 minutes at 90 °C.

For every photocondensation compound, 10 plates are prepared and 3 are selected from those wherein the weight of the dried diazonium compound remaining on the plate ranges from 0.8 to 0.83 $g/m^2$.

**TEST 2. PREPARATION OF PHOTOSENSITIVE PLATES BY ELECTROCATHODIC DEPOSITION**

A photosensitive emulsion is prepared consisting of:

2.3 parts of a photosensitive polycondensation compound,

97.6 parts of dimethylformamide, and

0.1 parts of a conventional soluble dyestuff (HEKTOVIOLET-612™ , BASF).

The emulsion is cathodically deposited, as described in US-A-4.533.620, onto aluminium plates, such as those described in Test 1, in such a quantity that the amount of the dried photosensitive polycondensation compound (dried in an air-circulation oven at 90 °C for 5 minutes) deposited on the plate ranges from 0.8 to 0.85 $g/m^2$. Also in this case 10 plates are prepared and three are selected from those wherein the weight of the dried diazonium compound ranges between the predetermined limits.

**TEST 3. DEVELOPING AND PRINTING PERFORMANCE**

For every photosensitive polycondensation compound, at least two photosensitive plates, prepared with each of the two previous Methods, are placed in an exposure apparatus at 1.4 meters from a 4,000 Watt lamp having an emission spectrum comprised between 280 and 420 nm. Onto each plate there are placed a Stauffer Graphic Arts scale (graduated from 1 to 21), an Ugra scale (graduated from 1 to 13) and, if desired, other scales useful to evaluate the quality of the image.

A glass plate with a membrane is placed onto the photosensitive plate upon which the scales have been placed and a vacuum is applied (40 mmHg) to aid a perfect contact between the scale and the photosensitive surface of the plate.

When the predetermined vacuum is reached the photosensitive plates are irradiated for 90 seconds.

The photosensitive emulsion unexposed to the light is removed (without using mechanical means) by submerging the exposed plate for 1.5 minutes in a basin containing 2.5 l of a developing solution at 25°C. The developing solution made of:

10 parts of triethanolamine dodecylbenzenesulfonate;
15 parts of sodium salicylate;
6.5 parts of triethanolamine;
0.2 parts of a siliconic emulsion, and;
68.3 parts of water.

The plate is then washed in a basin containing 2.5 l of water at 25°C for 3 minutes and dried at 60°C for 3 minutes.

The developing liquid and the washing solution are substituted each time the treatment cycle of the photosensitive plates (2), containing the same photosensitive polycondensation compound, is completed.

The result is considered a good one when the developed parts which have not been exposed to the light or have only been partially exposed to the light show no traces of undissolved photosensitive polycondensation compound nor have yellow residues nor have yellowish shadows.

The number of copies printed with every plate (0.15 mm thick) thus obtained was also measured. Printing was performed using a lithographic printing machine from the Japanese company Roneo and was interrupted when the screen of the Ugra scale marked with 3% was no longer printed.

The results obtained by using the compounds of the present invention and the comparison compounds are shown in the following Tables 13 and 14.

PLATES PREPARED BY CONTACT

Table 13

| Plate No. | polycondensation compound | | Compound B Purity | Printed Copies | Notes |
|---|---|---|---|---|---|
| | Example No. | Comparative Example No. | | | |
| 1 | 1 | | 68.8% | 76,000 | no yellow shadow |
| 2 | 2 | | 98.0% | 85,000 | same |
| 3 | | 1 | 68.8% | 10,000 | same |
| 4 | | 2 | 68.8% | 9,000 | same |
| 5A | | 3A | 77.0% | 10,000 | same |
| 5B | | 3B | 77.0% | 15,000 | same |
| 5C | 3C | | 77.0% | 78,000 | same |
| 5D | 3D | | 98.2% | 84,000 | same |

After exposure and development all the photosensitive plates have reproduced good images.

None of the solutions of the photosensitive polycondensation compounds used to produce the plates of Table 13 undergo degradation at 27°C over a period of 120 h.

PLATES PREPARED BY ELECTROCATHODIC DEPOSITION

Table 14

| Plate No. | polycondensation compound | | Compound B Purity | Printed Copies | Notes |
|---|---|---|---|---|---|
| | Example No. | Comparative Example No. | | | |
| 1A | 1 | | 68.8% | 98.000 | no yellow shadow |
| 2A | 2 | | 98.0% | 140,000 | same |
| 5A1 | | 3A | 77.0% | 15,000 | same |
| 5B1 | | 3B | 77.0% | 35,000 | same |
| 5C1 | 3C | | 77.0% | 125,000 | same |
| 5D1 | 3D | | 98.2% | 150,000 | same |
| 6A | | 4A | 29.5% | 18,000 | same |
| 6B | | 4B | 29.5% | 25,000 | same |
| 6C | 4C | | 29.5% | 120,000 | same |
| 6D | 4D | | 98.0% | 142,000 | same |

After exposure and development all the photosensitive plates have reproduced good images.

Among all the solutions of the photosensitive polycondensation compounds used to produce the plates of Table 14, only those of the plates 6A and 6B underwent degradation at 27°C after 120 h.

**TEST 4. MECHANICAL RESISTANCE**

After exposure to light, developing and drying as described in the previous Test 3, each plate prepared as described in the previous Tests 1 and 2 was placed under an abrasion meter consisting of a rotating cylinder covered by paper.

The rotating cylinder has a diameter of 3 cm, is actuated by an electric motor and exerts a pressure of 100 g/cm$^2$ on the photosensitive surface.

The rotating cylinder was actuated for 1 minute at 25°C at a speed of 100 rpm.

The lithographic plate was weighed before and after abrasion. The quantity of emulsion removed has been expressed in terms of the percentage by weight and this percentage has been considered to be an index of the mechanical resistance of the photosensitive coating applied to the aluminium support.

The results of this test are shown in the following Tables 15 and 16.

The abrasion resistance can also be determined by measuring, with a Gretag densitometer, the difference in colour intensity between one portion of the plate surface which has undergone abrasion and another portion which has not undergone abrasion.

The results of this test are shown in the following Tables 17 and 18.

PLATES PREPARED BY CONTACT

Table 15

| Plate No. | polycondensation compound | | Compound B Purity | Printed Copies | Average Weight of Coating Removed by Abrasion |
|---|---|---|---|---|---|
| | Example No. | Comparative Example No. | | | |
| 1 | 1 | | 68.8% | 76,000 | 6.0% |
| 2 | 2 | | 98.0% | 85,000 | 5.0% |
| 3 | | 1 | 68.8% | 10,000 | 43.0% |
| 4 | | 2 | 68.8% | 9,000 | 48.0% |
| 5A | | 3A | 77.0% | 10,000 | 42.0% |
| 5B | | 3B | 77.0% | 15,000 | 29.0% |
| 5C | 3C | | 77.0% | 78,000 | 5.5% |
| 5D | 3D | | 98.2% | 84,000 | 5.0% |

PLATES PREPARED BY CATHODIC DEPOSITION

Table 16

| Plate No. | polycondensation compound | | Compound B Purity | Printed Copies | Average Weight of Coating Removed by Abrasion |
|---|---|---|---|---|---|
| | Example No. | Comparative Example No. | | | |
| 1A | 1 | | 68.8% | 98,000 | 4.5% |
| 2A | 2 | | 98.0% | 140,000 | 3.0% |
| 5A1 | | 3A | 77.0% | 15,000 | 28.8% |
| 5B1 | | 3B | 77.0% | 35,000 | 12.0% |
| 5C1 | 3C | | 77.0% | 125,000 | 3.5% |
| 5D1 | 3D | | 98.2% | 150,000 | 2.8% |
| 6A | | 4A | 29.5% | 18,000 | 24.4% |
| 6B | | 4B | 29.5% | 25,000 | 17.5% |
| 6C | 4C | | 29.5% | 120,000 | 3.8% |
| 6D | 4D | | 98.0% | 142,000 | 3.0% |

PLATES PREPARED BY CONTACT

Table 17

| Plate No. | polycondensation compound | | Compound B Purity | Printed Copies | Average Weight of Coating Removed by Abrasion |
|---|---|---|---|---|---|
| | Example No. | Comparative Example No. | | | |
| 1 | 1 | | 68.8% | 76,000 | 3% |
| 2 | 2 | | 98.0% | 85,000 | 1% |
| 3 | | 1 | 68.8% | 10,000 | 8% |
| 4 | | 2 | 68.8% | 9,000 | 25% |
| 5A | | 3A | 77.0% | 10,000 | 53% |
| 5B | | 3B | 77.0% | 15,000 | 19% |
| 5C | 3C | | 77.0% | 78,000 | 1% |
| 5D | 3D | | 98.2% | 84,000 | 1% |

PLATES PREPARED BY CATHODIC DEPOSITION

Table 18

| Plate No. | polycondensation compound | | Compound B Purity | Printed Copies | Average Weight of Coating Removed by Abrasion |
|---|---|---|---|---|---|
| | Example No. | Comparative Example No. | | | |
| 1A | 1 | | 68.8% | 98,000 | 1% |
| 2A | 2 | | 98.0% | 140,000 | 0% |
| 5A1 | | 3A | 77.0% | 15,000 | 17% |
| 5B1 | | 3B | 77.0% | 35,000 | 4% |
| 5C1 | 3C | | 77.0% | 125,000 | 1% |
| 5D1 | 3D | | 98.2% | 150,000 | 0% |
| 6A | | 4A | 29.5% | 18,000 | 6% |
| 6B | | 4B | 29.5% | 25,000 | 3% |
| 6C | 4C | | 29.5% | 120,000 | 1% |
| 6D | 4D | | 98.0% | 142,000 | 0% |

**TEST 5. SOLVENTS RESISTANCE**

After exposure to light, developing and drying, as described in the previous Test 3, 2 ml of ethylene glycol monomethyl ether were placed for 30 seconds at 25 °C onto each plate, prepared as described in the previous Tests 1 and 2.

The drop was dried in a hot air current at 65 °C for 1 minute.

A different discolouration was noted.

On each plate the colour intensity both at the centre of the trace left by the ethylene glycol monomethyl ether ($I_1$) and on a portion unexposed to the solvent ($I_2$) was measured by means of a Gretag densitometer.

The difference in the percentage between the two intensities was considered to be an index of the resistance to the solvents of the photosensitive coating applied to the aluminium support.

The results of this test are shown in the following Table 19.

Table 19

| Plate No. | Example No. | Compar. Example No. | Compound B Purity | I2 | I1 | I2-I1 100 |
|---|---|---|---|---|---|---|
| 1 | 1 | | 68.8% | 1.57 | 1.53 | 3 |
| 1A | 1 | | 68.8% | 1.53 | 1.53 | 1 |
| 2 | 2 | | 98.0% | 1.57 | 1.55 | 1 |
| 2A | 2 | | 98.0% | 1.54 | 1.54 | 0 |
| 3 | | 1 | 68.8% | 1.57 | 1.46 | 8 |
| 4 | | 2 | 68.8% | 1.58 | 1.26 | 25 |
| 5A | | 3A | 77.0% | 1.56 | 1.02 | 53 |
| 5A1 | | 3A | 77.0% | 1.56 | 1.33 | 17 |
| 5B | | 3B | 77.0% | 1.56 | 1.31 | 19 |
| 5B1 | | 3B | 77.0% | 1.57 | 1.51 | 4 |
| 5C | 3C | | 77.0% | 1.57 | 1.55 | 1 |
| 5C1 | 3C | | 77.0% | 1.57 | 1.56 | 1 |
| 5D | 3D | | 98.2% | 1.56 | 1.55 | 1 |
| 5D1 | 3D | | 98.2% | 1.57 | 1.57 | 0 |
| 6A | | 4A | 29.5% | 1.59 | 1.50 | 6 |
| 6B | | 4B | 29.5% | 1.57 | 1.52 | 3 |
| 6C | 4C | | 29.5% | 1.55 | 1.54 | 1 |
| 6D | 4D | | 98.0% | 1.56 | 1.56 | 0 |

**TEST 6. PHOTOSENSITIVITY**

At least two plates, prepared as described in the previous Tests 1 and 2, were examined after exposure to light, developing and drying, as described in the previous Test 3, with respect to the grades of the Stauffer and Ugra scales.

Only the completely full grades (viz. unfaded) are considered and the photosensitivity of the photosensitive polycondensation compound is determined according to the number (Stauffer: from 1 to 21; Ugra from 1 to 13) of the last grade which has practically the same colour as the emulsion exposed to the light but on which the scale was not placed.

The higher the quantity of "full" grades on the plate examined, the higher is the photosensitivity of the emulsion, and thus of the photosensitive polycondensation compound applied to the plate.

The results of this test are shown in the following Tables 20 and 21.

PLATES PREPARED BY CONTACT

Table 20

| Plate No. | Example No. | Compar. Example No. | Compound B Purity | Printed Copies No. | Stauffer (1-21) | Ugra (1-13) |
|---|---|---|---|---|---|---|
| 1 | 1 | | 68.8% | 76,000 | 4-5 | 4 |
| 2 | 2 | | 98.0% | 85,000 | 5-6 | 5 |
| 3 | | 1 | 68.8% | 10,000 | 2-3 | 2 |
| 4 | | 2 | 68.8% | 9,000 | 1-2 | 1 |
| 5A | | 3A | 77.0% | 10,000 | 1-2 | 1 |
| 5B | | 3B | 77.0% | 15,000 | 2-3 | 2 |
| 5C | 3C | | 77.0% | 78,000 | 4-5 | 4 |
| 5D | 3D | | 98.2% | 84,000 | 5-6 | 5 |

PLATES PREPARED BY CATHODIC DEPOSITION

Table 21

| Plate No. | Example No. | Compar. Example No. | Compound B Purity | Printed Copies No. | Stauffer (1-21) | Ugra (1-13) |
|---|---|---|---|---|---|---|
| 1A | 1 | | 68.8% | 98,000 | 7-8 | 7 |
| 2A | 2 | | 98.0% | 140,000 | 9 | 8 |
| 5A | | 3A | 77.0% | 15,000 | 2-3 | 2 |
| 5B | | 3B | 77.0% | 35,000 | 4 | 3 |
| 5C | 3C | | 77.0% | 125,000 | 5-6 | 4-5 |
| 5D | 3D | | 98.2% | 150,000 | 6-7 | 6 |
| 6A | | 4A | 29.5% | 18,000 | 4 | 3 |
| 6B | | 4B | 29.5% | 25,000 | 5 | 4-5 |
| 6C | 4C | | 29.5% | 120,000 | 6 | 5-6 |
| 6D | 4D | | 98.0% | 142,000 | 7 | 6 |

## Claims

1. A process for condensing in an acid medium, an aromatic diazonium compound of the formula:

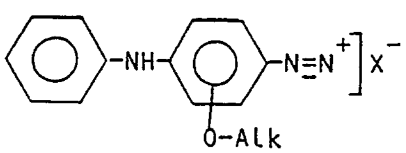

(A)

with an alkoxymethyl compound of the formula:

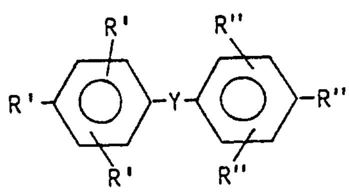

(B)

where $X^-$ is $HSO_4{}^-$, $Cl^-$, $H_2PO_4{}^-$;
Y is O, NH, S, $CH_2$, $C(CH_3)_2$, CH(OH)CO , CO, CONH, SO, or CH = CH;
one or two R' substituents are Alk-O-$CH_2$ and the remaining R' substituents are hydrogen;
from zero to two R'' substituents are Alk-O-$CH_2$ and the remaining R'' substituents are hydrogen;
Alk is an alkyl having from one to four carbon atoms. characterized in that the condensation medium is a mixture containing from 30 to 5 parts by weight of 98% aqueous methanesulfonic acid and from 70 to 95 parts by weight of 85% aqueous phosphoric acid, respectively.

2. A process according to claim 1, characterized in that the condensation medium is made of from 20 to 7 parts by weight of 98-99% aqueous methanesulfonic acid and from 80 to 95 parts by weight of 85% aqueous phosphoric acid, respectively.

3. A process according to any of claims 1 and 2, characterized in that the from 50 to 60 parts by weight of A are reacted with from 40 to 50 parts by weight of B.

4. A process according to any of claims from 1 to 3, characterized in that compound A is dissolved in the acid medium and then the compound B is added.

5. A process according to any of claims from 1 to 4, characterized in that the polycondensation reaction is carried out at a temperature lower than 70 ° C.

6. A process according to the previous claim 5, characterized in that the polycondensation reaction is carried out at a temperature of from 24 to 32 ° C.

7. A process according to any of claims from 1 to 6, characterized in that the polycondensation reaction is carried out for less than 36 hours.

8. A process according to any of claims from 1 to 7, characterized in that the polycondensation compound is freeze dried as soon as it is prepared.

9. A photosensitive polycondensation compound containing from 50 to about 60% by weight of A and from 40 to about 50% by weight of compound B units characterized in that
   - it has been prepared by condensation, in an acid medium, of from 50 to 60 parts by weight of an aromatic diazonium compound of the formula:

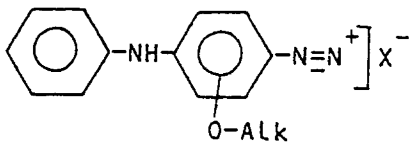

(A)

with from 40 to 50 parts by weight of an alkoxymethyl compound of the formula:

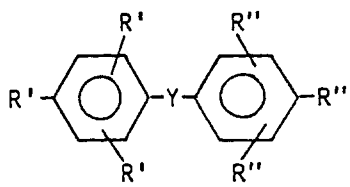

(B)

where $X^-$ is $HSO_4{}^-$, $Cl^-$, $H_2PO_4{}^-$;
Y is O, NH, S, $CH_2$, $C(CH_3)_2$, CH(OH)CO , CO, CONH, SO, or CH = CH;
one or two R' substituents are Alk-O-$CH_2$ and the remaining substituents R' are hydrogen;
from zero to two R" substituents are Alk-O-$CH_2$ and the remaining R" substituents are hydrogen;
Alk is an alkyl having from one to four carbon atoms,
said acid medium being a mixture of from 30 to 5 parts by weight of 98% aqueous methanesulfonic acid and of from 70 to 95 parts by weight of 85% aqueous phosphoric acid, respectively,
   - it has a mean molecular weight higher than 3.000.

10. A photosensitive polycondensation compound according to claim 9, characterized in that it has been prepared in a condensation medium made of from 20 to 7 parts by weight of 98-99% aqueous methanesulfonic acid and of from 80 to 95 parts by weight of 85% aqueous phosphoric acid.

11. A photosensitive polycondensation compound according to claim 9 or 10, characterized in that it has been prepared by reacting from 50 to about 60 parts by weight of A with from 40 to about 50 parts by weight of compound B units.

12. A photosensitive polycondensation compound according to any of claims from 9 to 11, characterized in that it has been prepared that by dissolving compound A in the acid medium and then adding compound B.

13. A photosensitive polycondensation compound according to any of claims from 9 to 12, characterized in that it has been prepared by carrying out the polycondensation reaction at a temperature lower than

70 ° C.

**14.** A photosensitive polycondensation compound according to claim 13, characterized in that it has been prepared by carrying out the polycondensation reaction at a temperature of from 24 to 32 ° C.

**15.** A photosensitive polycondensation compound according to any of claims from 9 to 14, characterized in that it has been prepared by carrying out the polycondensation reaction for less than 36 hours.

**16.** A photosensitive polycondensation compound according to any of claims from 9 to 15, characterized in that it has been prepared by freeze drying the polycondensation compound as soon as it is prepared.

**17.** A printing plate characterized in that the photosensitive element comprises at least polycondensation compound containing from 50 to about 60% by weight of A and from 40 to about 50% by weight of compound B units and that

- it has been prepared by condensation, in an acid medium, of from 50 to 60 parts by weight of an aromatic diazonium compound of the formula:

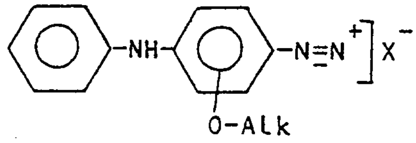

(A)

with from 40 to 50 parts by weight of an alkoxymethyl compound of the formula:

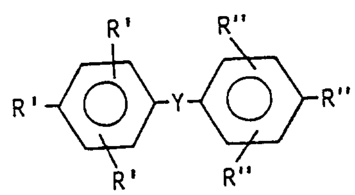

(B)

where $X^-$ is $HSO_4^-$, $Cl^-$, $H_2PO_4^-$;

Y is O, NH, S, $CH_2$, $C(CH_3)_2$, CH(OH)CO , CO, CONH, SO, or CH = CH;

one or two R' substituents are Alk-O-$CH_2$ and the remaining substituents R' are hydrogen;

from zero to two R'' substituents are Alk-O-$CH_2$ and the remaining R'' substituents are hydrogen;

Alk is an alkyl having from one to four carbon atoms,

said acid medium being a mixture of from 30 to 5 parts by weight of 98% aqueous methanesulfonic acid and of from 70 to 95 parts by weight of 85% aqueous phosphoric acid, respectively,

- it has a mean molecular weight higher than 3.000.

**18.** A printing plate according to claim 17, characterized in that the photosensitive polycondensation compound has been prepared in a condensation medium made of from 20 to 7 parts by weight of 98-99% aqueous methanesulfonic acid and of from 80 to 95 parts by weight of 85% aqueous phosphoric acid.

**19.** A printing plate according to claim 17 or 18, characterized in that the photosensitive polycondensation compound has been prepared by reacting from 50 to about 60 parts by weight of A with from 40 to about 50 parts by weight of compound B units.

**20.** A printing plate according to any of claims from 17 to 19, characterized in that the photosensitive polycondensation compound has been prepared by dissolving compound A in the acid medium and then adding compound B.

**21.** A printing plate according to any of claims from 17 to 20, characterized in that the photosensitive polycondensation compound has been prepared by carrying out the polycondensation reaction at a temperature lower than 70 °C.

**22.** A printing plate according to claim 21, characterized in that the photosensitive polycondensation compound has been prepared by carrying out the polycondensation reaction at a temperature of from 24 to 32 °C.

**23.** A printing plate according to any of claims from 17 to 22, characterized in that the photosensitive polycondensation compound has been prepared by carrying out the polycondensation reaction for less than 36 hours.

**24.** A printing plate according to any of claims from 17 to 23, characterized in that the photosensitive polycondensation compound has been prepared by freeze drying the polycondensation compound as soon as it is prepared.

European Patent Office

# EUROPEAN SEARCH REPORT

Application Number
EP 94 20 0771

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| A | DE-A-20 24 243 (AZOPLATE CORPORATION) * page 15, paragraph 4; claims 1-4 * | 1-24 | G03F7/021<br>C08G61/12 |
| A | EP-A-0 126 875 (HOECHST AKTIENGESELLSCHAFT) * page 10, line 29 - line 30 * * page 11, line 1 - line 30; claims * | 1-24 | |
| A | EP-A-0 224 162 (HOECHST AKTIENGESELLSCHAFT) * page 5, line 6 - line 9; claims * | 1-24 | |
| A,D | EP-A-0 135 616 (AMERICAN HOECHST CORPORATION) * page 5, line 28 - line 30 * * page 6, line 22 - line 26 * | 1-24 | |

TECHNICAL FIELDS SEARCHED (Int.Cl.5)
G03F
C08G

The present search report has been drawn up for all claims

| Place of search | Date of completion of the search | Examiner |
|---|---|---|
| THE HAGUE | 25 July 1994 | J.-M. DUPART |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)